# EUROPÄISCHE PATENTSCHRIFT

(11) **EP 0 538 805 B1**
(45) Veröffentlichungstag und Bekanntmachung des Hinweises auf die Patenterteilung: **04.03.1998**
(21) Anmeldenummer: 92117946.1
(22) Anmeldetag: 20.10.1992
(51) Int. Cl.: H03M 13/00, G06F 7/62, H03K 23/58, H03K 21/14, G06F 7/50, G11C 19/00

(54) **Addier-Vergleichs-Auswahl (ACS) Schmetterlingsschaltung für Viterbidekodierer, bei der die Addiervorgänge von Zählern ausgeführt werden**
Add-Compare-Select (ACS) butterfly circuit for Viterbi decoder in which the adding operations are carried out by counters
Circuit d'addition-comparaison-sélection (ACS) en papillon dans lequel les additions sont effectuées par des compteurs

(30) Priorität: 25.10.1991 DE 4135318
(43) Veröffentlichungstag der Anmeldung: 28.04.1993
(73) Patentinhaber: SIEMENS AKTIENGESELLSCHAFT, 80333 München (DE)
(72) Erfinder: Grehl, Udo, Dipl.-Ing., W-8000 München 90 (DE)

(56) Entgegenhaltungen:
- FR-A- 2 261 663
- US-A- 3 699 534
- US-A- 5 027 374
- PATENT ABSTRACTS OF JAPAN vol. 13, no. 155 (E-743) 14. April 1989 & JP-A-63 312 722 (SANYO ELECTRIC CO. LTD.) 21. Dezember 1988
- PROCEEDING OF THE IEEE 1987 CUSTOM INTEGRATED CIRCUITS CONFERENCE, PORTLAND, US, 04.-07.05.1987, 4. Mai 1987, IEEE, NEW YORK,US Seiten 551 - 554 J. STAHL / H. MEYR: 'A bit serial Viterbi decoder chip for the Mbit/s range.'

## Beschreibung

Die Erfindung betrifft eine Schaltungsanordnung nach dem Oberbegriff des Patentanspruches 1.

Die digitale Datenübertragung über Sateliten- und Mobilfunkkanäle erfordert Übertragungsverfahren, die jeweils die zur Verfügung stehende Bandbreite und Sendeleistung effektiv nutzen. Die Effektivität derartiger Verfahren hängt im wesentlichen von dem dabei verwendeten Dekodierverfahren ab. Ein optimales Decodierverfahren im Sinne des Maximum-Likelihood-Kriteriums stellt bei entsprechender Sendesignalcodierung der sogenannte Viterbi-Algorithmus dar.

Der Viterbi-Algorithmus beruht im Prinzip auf einer Wegsuche in einem Diagramm, dem sogenannten Trellis-Diagramm, das alle möglichen Zustandsänderungen eines gegebenen Codes zwischen bestimmten Zeitpunkten wiedergibt. Es wird dabei der Weg gesucht, der bei der Codierung am wahrscheinlichsten eingeschlagen wurde (Maximum-Likelihood-Prinzip). Als Maß für die Wahrscheinlichkeit eines Weges wird der metrische Abstand, kurz Metrik genannt, verwendet. Bei dem Übergang von einem Zeitpunkt k nach einem kleinen Zeitpunkt k + 1, auch als Level k bzw. k + 1 bezeichnet, wird der metrische Abstand zwischen einem empfangenen Codewort und jedem möglichen Codewort, jeweils einem Weg entsprechend, ermittelt. Gemäß dem Maximum-Likelihood-Prinzip ist bei minimaler Metrik die Wahrscheinlichkeit am größten. Der Weg mit geringster Metrik wird als Survivor bezeichnet.

Die Decodierung anhand des Viterbi-Algorithmus läßt sich in zwei Arbeitsphasen aufteilen, nämlich in eine Vorwärtsphase und in eine Rückwärtsphase. Bei der Vorwärtsphase werden Informationen über die Wahrscheinlichkeit jedes einzelnen Übergangs gesammelt. Da zu einem neuen Zustand jeweils zwei Wege führen, wird dabei der Survivor ausgewählt, also der Weg mit der geringeren Metrik. Der Survivor wird mit einem Bit codiert, wobei einem Weg eine logiscne "0" und dem anderen Weg eine logische "1" zugeordnet ist. Bei der Rückwärtsphase wird die Information anhand der Survivorcodierungen rekonstruiert.

Die Zustandsübergänge zwischen zwei Levels bilden regelmäßige, logische Strukturen, sogenannte Schmetterlingsstrukturen, die eine Verwendung relativ einfach aufgebauter Schaltungsteile bei einem nach dem Viterbi-Algorithmus arbeitenden Decoder erlauben. Dabei ist prinzipiell sowohl eine parallele als auch serielle Verarbeitung möglich. Die parallele Verarbeitung gestattet gegenüber der seriellen Verarbeitung höhere Datenraten einerseits, bedarf andererseits jedoch eines höheren schaltungstechnischen Aufwands, der wiederum einen höheren Stromverbrauch nach sich zieht. Insbesondere bei Anwendungen im Mobilfunkbereich wird daher eine serielle Verarbeitung bevorzugt.

Eine seriell arbeitende Schaltungsanordnung zur Erzeugung logischer Schmetterlingsstrukturen ist beispielsweise aus J. Stahl, A. Meyr, A Bit Serial Viterbi-Decoder Chip For MBit/s Range, IEEE Custom Integrated Circuits Conference, 1987, S. 551 bis 554 bekannt. Diese, auch bitserielle Add-Compare- Select-Cell genannte Schaltungsanordnung besteht aus zwei seriellen Volladdierern zur Addition jeweils einer der beiden alten Metriken mit einer für den jeweiligen Weg charakteristischen Zweigmetrik. Den beiden Volladdierern sind jeweils eine Reihe von Speicherelementen nachgeschaltet, die jeweils ein Schieberegister bilden. Diese beiden Schieberegister führen jeweils auf einen Multiplexer, der abhängig von einem Steuersignal eines von beiden durchschaltet. Das Steuersignal wird durch einen seriellen Komparator erzeugt, der die um eine Stelle verzögerten Ergebnisse der beiden Additionen miteinander vergleicht, und anschließend um eine Stelle verzögert dem Multiplexer zugeführt.

Nachteile sind die Notwendigkeit, zusätzlichen Schaltungsaufwandes zur Realisierung komplexerer Steuerfunktionen und die Fehlerhaftigkeit des Ergebnisses.

Aufgabe der Erfindung ist es, eine gattungsgemäße Schaltungsanordnung anzugeben, die diese Nachteile nicht aufweist.

Die Aufgabe wird bei einer gattungsgemäßen Schaltungsanordnung durch die kennzeichnenden Merkmale des Patentanspruches 1 gelöst.

Eine Ausgestaltung des Erfindungsgedankens ist Gegenstand eines Unteranspruches.

Die Erfindung wird nachfolgend anhand des in den Figuren der Zeichnung dargestellten Ausführungsbeispiels näher erläutert.

Es zeigt:
- FIG 1: eine erste allgemeine Ausführungsform einer erfindungsgemäßen Schaltungsanordnung für zwei Metriken,
- FIG 2: das Trellis-Diagramm einer Schaltungsanordnung nach FIG 1,
- FIG 3: eine Ausführungsform eines Zählers bei einer erfindungsgemäßen Schaltungsanordnung und
- FIG 4: eine weitere Ausführungsform eines Zählers bei einer erfindungsgemäßen Schaltungsanordnung.

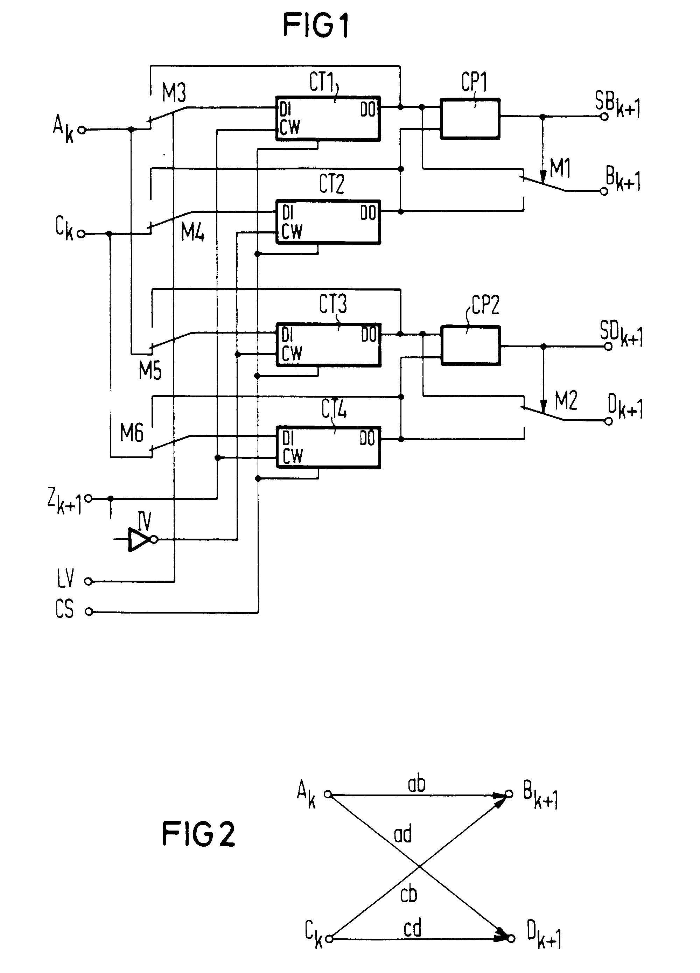

Die Schaltungsanordnung nach FIG 1 enthält k = 2 Verknüpfungszellen, die jeweils einen der beiden Ausgangszustände aus den beiden Eingangszuständen erzeugt. Die Verknüpfungszellen weisen dabei jeweils zwei Zähler CT1, CT2 bzw. CT3, CT4 auf, bei denen jeweils ein über einen seriellen Dateneingang DI geladener Zählerstand um einen über einen seriellen Zählweiteneingang CW eingegebenen Wert erhöht wird. Außerdem ist jeweils ein Komparator CP1 bzw. CP2 vorgesehen, der mit seriellen Datenausgängen DO der entsprechenden Zähler CT1, CT2 bzw. CT3, CT4 verbunden ist, und der seriell die beiden Zählerstände miteinander vergleicht. Den Datenausgängen DO der beiden entsprechenden Zähler CT1, CT2 bzw. CT3, CT4 sind jeweils Multiplexer M1 bzw. M2 nachgeschaltet, die durch die jeweiligen Komparatoren CP1 bzw. CP2 gesteuert einen der beiden Zählerstände als Ausgangszustand Bₖ₊₁ bzw. Dₖ₊₁ ausgeben. Jeweils zweiweitere Multiplexer M3, M4 bzw. M5, M6, die den Zählern CT1, CT2 bzw. CT3, CT4 jeweils vorgeschaltet sind, schalten entweder deren Datenausgänge DO oder den jeweils zugeordneten Eingangszustand Aₙ, Cₙ durch. Die Werte, die über die Zählweiteneingänge CW jeweils eingegeben werden, gehen aus einem Zweigmetrikwert Zₖ₊₁ dadurch hervor, daß der Zweigmetrikwert Zₖ₊₁ an die Zählweiteneingänge CW der Zähler CT1 und CT3 der Zweigmetrikwerk Zₙ₊₁ direkt und an die Zählweiteneingänge CW der Zähler CT2 und CT4 unter Zwischenschaltung eines Inverters IV angelegt ist. Die Steuerung der Multiplexer M3 bis M6 erfolgt mittels eines Signals LV und die Steuerung der Zähler CT1 bis CT4 mittels eines Signals CS.

Das Trellisdiagramm der Schaltungsanordnung nach FIG 1 enthält gemäß FIG 2 zwei Zustände Aₖ, Cₖ des Levels k, im folgenden mit alter Metrik bezeichnet, und zwei Zustände Bₖ₊₁, Dₖ₊₁ des Levels k + 1, im folgenden mit neuer Metrik bezeichnet. Der Zustand Bₖ₊₁ geht dabei entsprechend der Zustandsübergänge ab bzw. cb aus den Zuständen Aₖ und Cₖ hervor. Entsprechend ergibt sich der Zustand Dₖ₊₁ aus den Zuständen Aₖ und Cₖ durch die Übergänge ad bzw. cd.

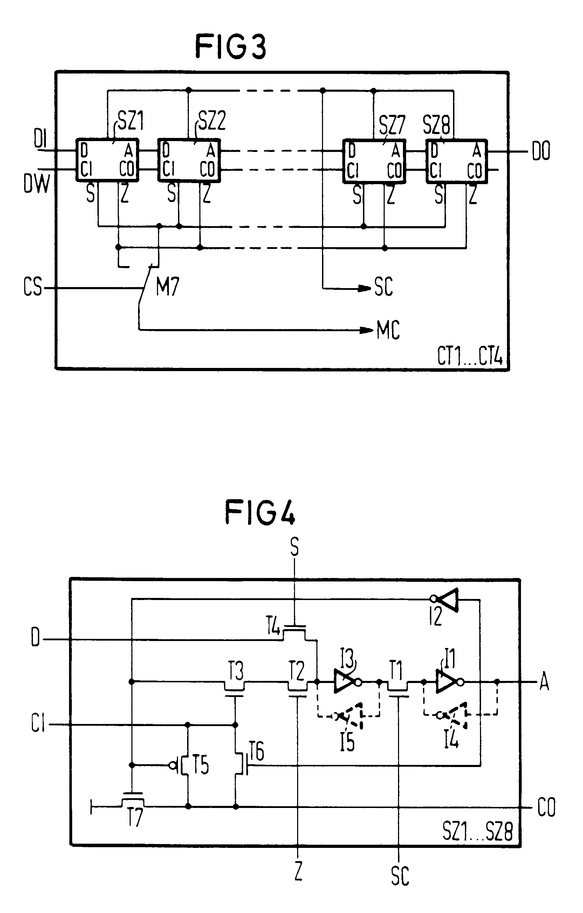

Bei dem gezeigten Ausführungsbeispiel enthalten gemäß FIG 3 die Zähler CT1 bis CT4 jeweils eine Anzahl von in Reihe geschalteten Speicherzellen SZ1 bis SZ8, die jeweils bezüglich der Dateneingänge D und der Datenausgänge A sowie bezüglich der Zählweiteneingänge ZI und der Zählweitenausgänge ZO in Reihe geschaltet sind. Dabei bildet der Dateneingang der Speicherzelle SZ1 den Dateneingang DI des jeweiligen Zählers CT1 bis CT4 und der Datenausgang A der letzten Speicherzelle SZ8 den Datenausgang DO des jeweiligen Zählers CT1 bis CT4. Außerdem ist als Zählweiteneingang CW des entsprechenden Zählers CT1 bis CT4 der Zählweiteneingang CI der ersten Speicherzelle SZ1 vorgesehen. Ein Mastertakt MC wird dabei über einen Multiplexer M7 in Abhängigkeit von dem Steuersignal CS zum einen auf einen Schiebemoduseingang S oder auf einen Zählmoduseingang Z aufgeschaltet. Abhängig davon, ob der Mastertakt MC an den Schiebe- oder Zählmoduseingang S, Z angelegt ist, führt der entsprechende Zähler CT1 bis CT4 Schiebe- oder Zähloperationen aus. Darüber hinaus sind die Speicherzellen SZ1 mit einem Slavetakt SC beaufschlagt.

Die Speicherzellen SZ1 bis SZ8 der Zähler CT1 bis CT4 enthalten gemäß FIG 4 jeweils einen Inverter I1, dessen Ausgang den Datenausgang A der jeweiligen Speicherzelle bildet, jeweils einen Inverter I2, dessen Eingang mit dem Ausgang des ersten Inverters I1 verbunden ist, sowie jeweils zwei MOS-Feldeffekttransistoren T1 und T2, deren Gateanschlüsse den Schiebe- bzw. Zählmoduseingang S, Z bilden und daher wahlweise mit dem Mastertakt MC beaufschlagt werden. Der Gateanschluß eines MOS-Feldeffekttransistors T3 ist mit einer Zählweiteneingangsleitung CI verbunden. Weiterhin sind jeweils ein Inverter I3, dessen Ausgang über die Source-Drain-Strecke des Transistors T1 mit dem Eingang des Inverters I1 und dessen Eingang über die in Reihe geschalteten Source-Drain-Strecken der Transistoren T2, T3 mit dem Ausgang des Inverters I2 verbunden ist, und jeweils ein Transistor T4, dessen Source-Drain-Strecke zwischen eine Dateneingangsleitung D und den Eingang des Inverters I3 geschaltet ist und dessen Gateanschluß den Schiebemoduseingang S bildet, vorgesehen. Zwei MOS-Feldeffekttransistoren T5 und T6, deren parallelgeschaltete Source-Drain- Strecken zwischen den Gateanschluß des Transistors T3 sowie einer Datenausgangsleitung A geschaltet sind und deren Gateanschlüsse jeweils mit den Ausgängen der Inverter I1, I2 verbunden sind, sind von unterschiedlichem Leitungstyp. So ist der Transistor T5 vom p-Kanal-Typ, während alle anderen Transistoren T1, T2, T3, T4, T6, T7 vom n-Kanal-Typ sind. Schließlich ist jeweils der MOS-Feldeffekttransistor T7, dessen Source-Drain-Strecke zwischen die Datenausgangsleitung A und ein Bezugspotential geschaltet ist, über seinen Gateanschluß mit dem Ausgang des Inverters I2 verbunden.

Zur Erläuterung der Funktionsweise einer erfindungsgemäßen Schaltungsanordnung sei im folgenden von einem beispielsweise im Mobilfunk häufig angewandten Faltungscode ausgegangen. Zur Berechnung von Deltametriken wird die Hamming-Distanz zwischen Codewort und Wegcode verwendet. Der Verfahrensablauf läßt sich dabei in drei Schritte einteilen: Zunächst werden die aus dem vorherigen Ablauf gewonnen alten Metriken Aₖ und Cₖ seriell in die entsprechenden Zähler CT1, CT3 bzw. CT2, CT4 geladen. Anschließend wird durch Zählen der Zählerstand entsprechend den Zweigmetriken des Levels k + 1 erhöht. Dies entspricht einer Addition der alten Metriken Aₖ und Cₖ mit den Zweigmetriken Zₖ₊₁. Die so gewonnen Metriken werden anschließend paarweise verglichen. Das Ergebnis des Vergleichs, nämlich ein entsprechender Survivor SBₖ₊₁ bzw. SDₖ₊₁, werden gespeichert. Das Vergleichsergebnis selektiert gleichzeitig die neuen Metriken Bₖ₊₁ bzw. Dₖ₊₁, die im nächsten Schritt wieder in die Zähler CT1 bis CT4 geladen werden. Neben der bisher gezeigten statischen Ausführungsform der Speicherzellen SZ1...SZ8 kann jedoch auch alternativ eine dynamische Ausführungsform eingesetzt werden. Diese geht aus der statischen Ausführungsform dadurch hervor, daß den Invertern I1 und I3 jeweils ein Inverter I4 bzw. I5 antiparallel geschaltet wird.

Vorteile erfindungsgemäßer Schaltungsanordnungen sind ein geringerer schaltungstechnischer Aufwand zur Realisierung von Steuerfunktionen, da die zur Verarbeitung der Daten bestimmte Logik gleichzeitig auch die Verwaltung der jeweiligen Metriken übernimmt. Insgesamt läßt sich daher ein Schaltungsentwurf leichter durchführen, was insbesondere durch die hohe Regularität der Strukturen sehr einfache layout-technische Realisierungen zulassen. Darüber hinaus ergeben sich gegenüber dem bekannten Verfahren weitere Vereinfachungen und insbesondere die Eliminierung des darin enthaltenen Fehlers.

## Patentansprüche

1. Schaltungsanordnung zur Durchführung einer Addier-Vergleich-Selektieroperation, bei der jeweils eine von k Verknüpfungszellen einen von k Ausgangszuständen aus zwei von k Eingangszuständen erzeugt,
**gekennzeichnet durch** Verknüpfungszellen mit jeweils zwei Zählern (CT1, CT2; CT3, CT4), die einen seriellen Dateneingang (DI), einen seriellen Datenausgang (DO) sowie einen seriellen Zählweiteneingang (CW) aufweisen und bei denen ein über den Dateneingang (DI) geladener, den jeweils zugeordneten Eingangszustand (Aₖ; Cₖ) repräsentierender Zählerstand um einen über den Zählweitengang (CW) eingegebenen Wert (Zₖ₊₁) erhöht wird, mit jeweils einem Komparator (CP1; CP2), der mit den Datenausgängen (D0) der beiden Zähler (CT1, CT2; CT3, CT4) verbunden ist und der seriell die beiden Zählerstände miteinander vergleicht, mit jeweils einem Multiplexer (M1; M2), der mit den Datenausgängen (D0) der beiden Zähler (CT1, CT2; CT3, CT4) verbunden ist und der durch den Komparator (CP1, CP2) gesteuert einen der beiden Zählerstände als Ausgangszustand (Bₖ₊₁; Dₖ₊₁) ausgibt, und
mit jeweils zwei weiteren Multiplexern (M3, M4; M5, M6), die den Zählern (CT1, CT2, CT3, CT4) jeweils vorgeschaltet sind und die zum Laden der Zählerstände die jeweils zugeordneten Eingangszustände (Aₖ; Cₖ) und zum Vergleichen der Zählerstände die Datenausgänge (D0) zu den jeweiligen Dateneingängen (DI) der Zähler (CT1, CT2, CT3, CT4) durchschalten.

2. Schaltungsanordnung nach Anspruch 1,
**dadurch gekennzeichnet,** daß die Zähler (CT1, CT2, CT3, CT4) jeweils eine Anzahl von in Reihe geschalteten Speicherzellen (SZ1 bis SZ8) aufweisen, bei denen abhängig von einem Steuerzustand (S, Z) Schiebeoperationen oder Zähloperationen durchgeführt werden.

3. Schaltungsanordnung nach Anspruch 2,
**gekennzeichnet durch** Speicherzellen (SZ1 bis SZ8) mit jeweils einem ersten Inverter (I1), dessen Ausgang den Datenausgang DO der jeweiligen Speicherzelle (SZ1 bis SZ8) bildet, mit jeweils einem zweiten Inverter (I2), dessen Eingang mit dem Ausgang des ersten Inverters (I1) verbunden ist, mit jeweils einem ersten und zweiten Transistor (T1, T2), deren Gateanschlüsse mit jeweils einer Taktleitung (Z, SC) verbunden sind,
mit jeweils einem dritten Transistor (T3), dessen Gateanschluß mit einer Zählweiteneingangsleitung (CI) verbunden ist,
mit jeweils einem dritten Inverter (I3), dessen Ausgang über die Source-Drain-Strecke des ersten Transistors (T1) mit dem Eingang des ersten Inverters (I1) und dessen Eingang über die in Reihe geschalteten Source-Drain-Strecken von zweiten und dritten Transistor (T3) mit dem Ausgang des zweiten Inverters (I2) verbunden ist,
mit jeweils einem vierten Transistor (T4), dessen Source-Drain-Strecke zwischen eine Dateneingangsleitung (D) und den Eingang des dritten Inverters (I3) geschaltet ist und dessen Gateanschluß mit einer weiteren Taktleitung (S) verbunden ist,
mit jeweils einem fünften und sechsten Transistor (T5, T6) von einander gegensätzlichem Leitungstyp, deren parallelgeschaltete Source-Drain-Strecken zwischen den Gateanschluß des dritten Transistors (T3) und einer Datenausgangsleitung (A) geschaltet sind und deren Gateanschlüsse jeweils mit den Ausgängen von erstem und zweitem Inverter (I1, I2) verbunden sind, und
mit jeweils einem siebten Transistor, dessen Source-Drain-Strecke zwischen die Datenausgangsleitung (A) und ein Bezugspotential geschaltet ist und dessen Gateanschluß mit dem Ausgang des zweiten Inverters (I2) verbunden ist.

4. Schaltungsanordnung nach Anspruch 3,
**dadurch gekennzeichnet,** daß dem ersten und dritten Inverter (I1, I3) jeweils ein vierter bzw. fünfter Inverter (I4, I5) antiparallel geschaltet ist.

## Claims

1. Circuit arrangement for carrying out an add-compare-select operation, in which each one of k logic cells produces one of k output states from two of k input states, characterized by logic cells each having two counters (CT1, CT2; CT3, CT4), which have a serial data input (DI), a serial data output (DO) and a serial count range input (CW), and in which a counter state, loaded via the data input (DI) and representing the respectively assigned input state (Aₖ; Cₖ) is increased by a value (Zₖ₊₁) input via the count range input (CW), each having a comparator (CP1; CP2), which is connected to the data outputs (DO) of the two counters (CT1, CT2; CT3, CT4) and which serially compares the two counter states with one another, each having a multiplexer (M1; M2) which is connected to the data outputs (DO) of the two counters (CT1, CT2; CT3, CT4) and which, under the control of the comparator (CP1, CP2), outputs one of the two counter states as output state (Bₖ₊₁; Dₖ₊₁), and each having two further multiplexers (M3, M4; M5, M6) which are respectively connected upstream of the counters (CT1, CT2, CT3, CT4) and which, in order to load the counter states, switch through the respectively assigned input states (Aₖ; Cₖ) and, for comparing the counter states, switch through the data outputs (DO) to the respective data inputs (DI) of the counters (CT1, CT2, CT3, CT4).

2. Circuit arrangement according to Claim 1, characterized in that the counters (CT1, CT2, CT3, CT4) each have a number of storage cells (SZ1 to SZ8) connected in series, for which shift operations or count operations are carried out as a function of a control state (S, Z).

3. Circuit arrangement according to Claim 2, characterized by storage cells (SZ1 to SZ8) each having a first invertor (I1) whose output forms the data output DO of the respective storage cell (SZ1 to SZ8), each having a second invertor (I2) whose input is connected to the output of the first invertor (I1), each having a first and a second transistor (T1, T2) whose gate electrodes are connected to a respective clock line (Z, SC), each having a third transistor (T3) whose gate electrode is connected to a count range input line (CI), each having a third invertor (I3) whose output is connected via the source-drain path of the first transistor (T1) to the input of the first invertor (I1) and whose input is connected via the source-drain paths, which are connected in series, of the second and of the third transistor (T3) to the output of the second invertor (I2), each having a fourth transistor (T4) whose source-drain path is connected between a data input line (D) and the input of the third invertor (I3) and whose gate electrode is connected to a further clock line (S), each having a fifth and a sixth transistor (T5, T6), of opposite conduction type, whose source-drain paths, connected in parallel, are connected between the gate electrode of the third transistor (T3) and a data output line (A) and whose gate electrodes are each connected to the outputs of the first and second invertors (I1, I2), and each having a seventh transistor whose source-drain path is connected between the data output line (A) and a reference potential and whose gate electrode is connected to the output of the second invertor (I2).

4. Circuit arrangement according to Claim 3, characterized in that a fourth or fifth invertor (I4, I5), respectively, is connected in anti-parallel with each of the first and third invertors (I1, I3).

## Revendications

1. Circuit pour l'exécution d'une opération d'addition-comparaison-sélection, dans lequel une de k cellules logiques produit l'un de k états de sortie à partir de deux de k états d'entrée,
caractérisé par des cellules logiques comprenant chacune :
deux compteurs (CT1, CT2 ; CT3, CT4) qui présentent une entrée de données série (Dl), une sortie de données série (DO) ainsi qu'une entrée d'amplitude de comptage série (CW), et dans lesquels un état de compteur chargé à travers l'entrée de données (Dl), représentant l'état d'entrée (Aₖ ; Cₖ) respectif, est augmenté d'une valeur (Zₖ₊₁) introduite à travers l'entrée d'amplitude de comptage (CW) ;
un comparateur (CP1 ; CP2) qui est relié aux sorties de données (DO) des deux compteurs (CT1, CT2 ; CT3, CT4) et qui compare en série les deux états de compteur entre eux ;
un multiplexeur (M1 ; M2) qui est relié aux sorties de données (DO) des deux compteurs (CT1, CT2 ; CT3, CT4) et qui, sous la commande du comparateur (CP1, CP2), émet l'un des deux états de compteur en tant qu'état de sortie (Bₖ₊₁, Dₖ₊₁) ; et
deux autres multiplexeurs (M3, M4 ; M5, M6) respectivement connectés en amont des compteurs (CT1, CT2, CT3, CT4) et qui transmettent aux entrées de données (Dl) respectives des compteurs (CT1, CT2, CT3, CT4), d'une part les états d'entrée (Aₖ ; Cₖ) respectivement associés, pour le chargement des états des compteurs, et, d'autre part, les sorties de données (DO), pour la comparaison des états des compteurs.

2. Circuit selon la revendication 1,
caractérisé en ce que les compteurs (CT1, CT2, CT3, CT4) présentent chacun un certain nombre de cellules de mémoire (SZ1 à SZ8) connectées en série, dans lesquelles il s'effectue des opérations de décalage ou des opérations de comptage, en fonction d'un état de commande (S, Z).

3. Circuit selon la revendication 2,
caractérisé par des cellules de mémoire (SZ1 à SZ8) comprenant chacune :
un premier inverseur (I1) dont la sortie forme la sortie de données (DO) de la cellule de mémoire considérée (SZ1 à SZ8) ;
un deuxième inverseur (12) dont l'entrée est reliée à la sortie du premier inverseur (I1) ;
un premier et un deuxième transistors (T1, T2) dont les connexions de porte sont reliées chacune à une ligne de cycle (Z, SC) ;
un troisième transistor (T3) dont la connexion de porte est reliée à une ligne d'entrée d'amplitude de comptage (CI) ;
un troisième inverseur (13) dont la sortie est reliée, à l'entrée du premier inverseur (I1) à travers le circuit source-drain du premier transistor (T1), et dont l'entrée est reliée à la sortie du deuxième inverseur (12), à travers les circuits source-drain connectés en série d'un deuxième et d'un troisième transistors (T3) ;
un quatrième transistor (T4) dont le circuit source-drain est connecté entre une ligne d'entrée de données (D) et l'entrée du troisième inverseur (13) et dont la connexion de porte est reliée à une autre ligne de cycle (S) ;
un cinquième et un sixième transistors (T5, T6) qui sont respectivement de types de conduction inverses l'un de l'autre, dont les circuits source-drain connectés en parallèle sont connectés entre la connexion de porte du troisième transistor (T3) et une ligne de sortie de données (A) et dont les connexions de porte sont reliées respectivement aux sorties du premier et du deuxième inverseurs (I1, I2) ; et
un septième transistor dont le circuit source-drain est connecté entre la ligne de sortie de données (A) et un potentiel de référence et dont la connexion de porte est reliée à la sortie du deuxième inverseur (I2).

4. Circuit selon la revendication 3,
caractérisé en ce qu'un quatrième et un cinquième inverseurs (14, 15) sont connectés respectivement en anti-parallèle par rapport au premier et au troisième inverseurs (I1, I3).
